# EUROPEAN PATENT SPECIFICATION

(11) **EP 0 916 112 B1**
(45) Date of publication and mention of the grant of the patent: **02.05.2001**
(21) Application number: 97932010.8
(22) Date of filing: 11.07.1997
(51) Int. Cl.: G03F 5/00, B41C 3/00

(54) **PROCESS FOR DRY FLEXOGRAPHIC AND OFFSET PRINTING**
VERFAHREN ZUM BEDRUCKEN DURCH TROCKENEN OFFSET- ODER FLEXODRUCK
PROCEDE D'IMPRESSION OFFSET ET FLEXOGRAPHIQUE A SEC

(30) Priority: 02.08.1996 IT PR960033
(43) Date of publication of application: 19.05.1999
(73) Proprietor: Ferri, Enzo, 43100 Parma (IT)
(72) Inventor: Ferri, Enzo, 43100 Parma (IT)
(74) Representative: Gotra, Stefano
(86) International application number: IT9700166
(87) International publication number: WO9806006

(56) References cited:
- EP-A- 0 418 052
- EP-A- 0 740 457
- WO-A-96/02868
- GB-A- 1 529 716

## Description

The present invention relates to a process for dry flexographic and offset printing, in particular for printing onto films of plastic material or containers and cans.

Printing of the dry offset type, which is a further development of lithographic printing, uses an indirect printing method in which the image is transferred from a matrix consisting of a metal or a photopolymer sheet to the article to be printed by means of a fabric or a rubber-coated roller.

Offset printing produces an indirect print in which the matrix has a raised rather than a flat form and essentially corresponds to lithographic printing without wetting.

Flexography is a printing method in which matrices made of rubber or a rubber-like elastic material (photopolymers, that is, light-sensitive polymers or elastomers) are used, for example, for printing directly onto paper, cardboard, plastic containers and cans, and bobbin-wound plastic films.

The matrix, whose printing parts appear in relief, is made to adhere to the surface of the printing cylinder and inked by means of an inking roller. Compared with offset printing, flexography is less costly and less complicated.

The printing quality, which initially is inferior to that of offset printing, has been improved over the years as a result of using flexographic half-tone screens and photopolymer matrices which make it possible to achieve a level of quality comparable to that of offset printing.

At present, in the case of both dry offset and flexographic printing, printing is performed by impression of a certain number of dots resulting from breakdown of the image into the four basic colours (yellow, red, blue and black), followed by printing through a half-tone screen.

If a print obtained using a traditional half-tone screen system is examined with a magnifying glass, it is possible to observe a series of fairly large dots whose size depends on the colour density (light or dark) in the examined area.

A more recent half-tone screen system, the so-called random or stochastic half-tone screen, which allows the print to be defined much more accurately (the dots being smaller and having the same size, and their concentration, that is their number per cm², being proportional to the type and degree of colour of the print) is also known, but is obtained by a much more delicate process which, if not carried out with the maximum care, can result in sheets which are stained or covered with rings.

It is in any case generally accepted that the random half-tone screen system can only be applied to lithographic printing on paper, but cannot be applied successfully to dry flexographic or offset printing on sheets made of flexible or plastic material, plastic containers and cans.

Indeed, the application of the random half-tone screen system to printing onto bobbin-wound flexible films has given rise to numerous drawbacks, and the quality of the final print has always turned out to be unsatisfactory and not recommendable for commercial use.

WO 96 02868 discloses a process for offset printing using a stochastic half-tone screen system which has not a good performance.

The object of the present invention is to eliminate the abovementioned drawbacks and provide an innovative printing process which makes it possible to apply the random or stochastic half-tone screen system successfully also to dry flexographic and offset printing of plastic films, plastic containers and cans, while obtaining excellent printing quality.

Said objects are fully achieved by the process according to the present invention which is characterized by the contents of the claims given below.

The process includes the following steps for producing the printing matrix:
- digital acquisition, by means of scanning, of the image to be printed;
- modification of the colour curves;
- use of a random half-tone screen
- printing of a positive film by means of a developer;
- production of a negative film using a half-tone screen in which the size of the individual dots is smaller than in the positive film;
- use of the negative film for producing the printing matrix.

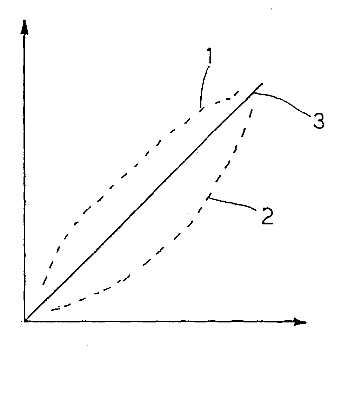

These and other characteristic features will become more apparent from the following description of a preferred embodiment of the process in which the sole figure shows a colour curve in which the colour value of the film is plotted on the abscissa and the colour value of the print is plotted on the ordinate and where the traditional modifications (Curve 1) and the innovative modifications according to the present invention (Curve 2) are compared to one another.

The first step of the present process is digital acquisition of the image to be printed (which can be, for example, in the form of a photograph or slide or sketch) by scanning the image itself which is broken down into the four basic colours (yellow, red, blue and black) and digitized. The scanned image may be stored on a magnetic medium or a CD-ROM.

The next step is to modify the colour curve manually or by means of a previously loaded software program. The technique of modifying the colours per se is already known, but the known technique produces a curve such as Curve 1 in the figure, that is, it results in an accentuation of colours, while one of the novelties of the present process consists in obtaining a decrease in accordance with, for example, Curve 2, namely below the theoretical straight line indicated at 3 in the figure. The particular type of printing has indeed the effect that during the printing step the colours on the article being printed are accentuated so that, in order to ensure that the colours on the printed article match those of the original as closely as possible, they need to be artificially "weakened" by computer during the intermediate stage of modifying the colour values. In the next step, the type of half-tone screen to be used is selected, and in this case in an original manner a random or stochastic half-tone screen with dots of about 50-60µm and preferably about 56µm in size was selected.

Use of a plotter and a developer then gives a positive film which, however, has to be transformed into a negative.

In the traditional method, said transformation is carried out in a contact printer by simple superposition.

However, such a method gives rise to a negative whose dot sizes are exactly identical to those of the positive film. Since the dots actually printed on the final article turn out to have a greater size than that of the film (as a result of the pressure exerted by the roller during the printing step which deforms the dots obtained in relief on the matrix), it is desirable to obtain a negative with a reduced dot size.

In the present process, the original feature is to obtain the negative film by interposing between it and the negative film a further film whose function is to refract the light in the contact printer.

As a result of said refraction, the Applicant has achieved a reduction in the size of dots equivalent to about 25-35%.

In particular, starting from an initial size of about 56-57µm, a dot size of about 39-40µm has been achieved, thus obtaining a negative half-tone screen which is considerably finer than the positive one.

According to a variant of the present process, rather than using an intermediate film, the reduction in the dot sizes can be obtained by means of prolonged exposure (about 8-15 seconds and preferably 10-12 seconds) using very powerful light. Preferably, the lamp is an 800 W metal halide burner free of ozone whose light intensity corresponds to the light intensity of a traditional copying system of 2,000-3,000 W, thanks to a well designed reflector construction. In any case, this lamp is not a subject-matter of the present invention.

The negative film obtained in one of the two ways indicated above is then used in an essentially known manner to produce the steel and polymer matrix (for dry offset printing) or rubber matrix (for flexographic printing) which is mounted on the printing machine.

The size of the dots on the matrix is about 65µm, starting from a negative of about 39-40µm, and the diameter of the individual dots on the printed article is about 75-109µm, depending on the type of printing.

This shows how important it is to obtain a preliminary reduction in the dot size during the transition from positive to negative film.

The present process thus allows the random half-tone screen system to be applied to dry offset and flexographic printing mainly via an original modification of the colour curves, a particular selection of the type of half-tone screen (dots of 50-60µm) and an original reduction in the dot sizes during the transition from the positive film to the negative film.

## Claims

1. Process for dry flexographic and offset printing, wherein the printing matrix is produced using a random or stochastic half-tone screen system, characterized in that it comprises the following steps for producing the printing matrix:
- digital acquisition, by means of scanning, of the image to be printed;
- modification of the colour curves;
- use of a random or stochastic half-tone screen;
- printing of a positive film by means of a developer;
- production of a negative film using a half-tone screen in which the size of the individual dots is smaller than in the positive film;
- use of the negative film for producing the printing matrix.

2. Process according to Claim 1, in which the modification of the colour curves consists in lowering the colour value below that of the theoretical curve or the standard colour.

3. Process according to Claim 1, in which a stochastic half-tone screen is used whose dots have a size of 50-60µm(preferably 56µm).

4. Process according to Claim 1, in which the size reduction of the dots takes place by means of refraction by interposing a sheet of film between the positive film and the negative film.

5. Process according to Claim 1, in which the size reduction of the dots takes place by producing the negative at a prolonged exposure of 8-15 seconds and preferably 10-12 seconds using light of 800 W.

6. Process according to Claim 1, in which the size reduction of the dots is equivalent to 25-35% of the initial size.

7. Process according to Claim 1, in which the individual dots are reduced from 56-57µm to 39-40µm during the transition from the positive to the negative film.

8. Process according to Claim 1, in which the size reduction of the dots in the negative film takes place in such a manner that the size of the individual dots in the final print is equal to the size of the individual dots in the positive film.

## Patentansprüche

1. Verfahren zum Bedrucken durch trockenen Offset- oder Flexodruck, wobei bei der Herstellung der Druckmatrize ein stochastisches Halbtonrastersystem zur Anwendung kommt, dadurch gekennzeichnet, dass es folgende Schritte zur Herstellung der Druckmatrize umfasst:
- ditigale Erfassung des zu druckenden Bildes durch Scannen;
- Beeinflussung der Farbkurven;
- Anwendung eines stochastischen Halbtonrasters;
- Drucken eines Positivfilms mithilfe einer Entwicklungsmaschine;
- Herstellen eines Negativfilms mithilfe eines Halbtonrasters, wobei die einzelnen Punkte des Negativfilms kleiner als die des Positivfilms sind;
- Nutzung des Negativfilms zur Herstellung der Druckmatrize.

2. Verfahren nach Anspruch 1, bei dem die Farbkurven derart verändert werden, dass der Farbwert unter denjenigen der theoretischen Kurve oder Standardfarbe abgesenkt wird.

3. Verfahren nach Anspruch 1, bei dem ein stochastische Halbtonraster zur Anwendung kommt, dessen Punkte eine Grösse von 50-60µm (vorzugsweise 56 µm) aufweisen.

4. Verfahren nach Anspruch 1, bei dem die Reduzierung der Punktgrösse durch Refraktion erfolgt, wobei ein Filmbogen zwischen den Positiv- und den Negativfilm gelegt wird.

5. Verfahren nach Anspruch 1, bei dem die Reduzierung der Punktgrösse durch Herstellen des Negativfilms mit einer längeren Belichtung von 8-15 Sekunden, vorzugsweise von 10-12 Sekunden, und einer Lichtstärke von 800 W erfolgt.

6. Verfahren nach Anspruch 1, bei dem die Grössenreduzierung der Punkte 25-35% der ursprünglichen Grösse beträgt.

7. Verfahren nach Anspruch 1, bei dem die einzelnen Punkte beim Übergang von dem Positiv- auf den Negativfilm von 56-57µm auf 39-40µm reduziert werden.

8. Verfahren nach Anspruch 1, bei dem die Grössenreduzierung der Punkte beim Negativfilm derart erfolgt, dass die Grösse der einzelnen Punkte des Enddruckes der Grösse der einzelnen Punkte des Positivfilms entspricht.

## Revendications

1. Procédé d'impression offset et flexographique à sec, où la matrice d'impression est réalisée en utilisant un système de tramage à demi-teintes aléatoire ou stochastique, caractérisé en ce qu'il comprend les phases suivantes pour réaliser la matrice d'impression :
- acquisition numérique, par balayage, de l'image à imprimer ;
- modification des courbes de couleur ;
- utilisation d'une trame à demi-teintes aléatoire ou stochastique ;
- impression d'un film positif au moyen d'un développeur ;
- production d'un film négatif avec une trame à demi-teintes dans laquelle la taille de chacun des points est inférieure à celle du film positif ;
- utilisation du film négatif pour produire la matrice d'impression.

2. Procédé selon la revendication 1, caractérisé en ce que la modification des courbes de couleur consiste à réduire la valeur de couleur en dessous de celle de la courbe théorique ou de la couleur standard.

3. Procédé selon la revendication 1, caractérisé en ce qu'une trame à demi-teintes stochastique est utilisée dont les points ont une taille de 50-60 µm (de préférence de 56 µm).

4. Procédé selon la revendication 1, caractérisé en ce que la réduction de la taille des points est effectuée par réfraction en plaçant une feuille de film entre le film positif et le film négatif.

5. Procédé selon la revendication 1, caractérisé en ce que la réduction de la taille des points est effectuée en réalisant le négatif avec une exposition prolongée de 8 à 15 secondes, de préférence de 10 à 12 secondes, sous une source lumineuse de 800 W.

6. Procédé selon la revendication 1, caractérisé en ce que la réduction de la taille des points éauivaut à 25-35 % de la taille initiale.

7. Procédé selon la revendication 1, caractérisé en ce que chaque point est réduit de 56-57 µm à 39-40 µm lors du passage du film positif au film négatif.

8. Procédé selon la revendication 1, caractérisé en ce que la réduction de la taille des points dans le film négatif a lieu de façon à ce que la taille de chaque point dans l'impression finale soit égale à la taille de chaque point dans le film positif.
